(19) **Europäisches Patentamt / European Patent Office / Office européen des brevets**

(11) **EP 4 201 847 A1**

(12) # EUROPEAN PATENT APPLICATION

(43) Date of publication:
**28.06.2023  Bulletin 2023/26**

(21) Application number: **21216562.5**

(22) Date of filing: **21.12.2021**

(51) International Patent Classification (IPC):
**B65G 23/22** *(2006.01)*    **B65G 23/24** *(2006.01)*
**H02K 1/18** *(2006.01)*    **H02K 7/06** *(2006.01)*
**H02K 7/116** *(2006.01)*    **H02K 37/12** *(2006.01)*
**H05K 13/04** *(2006.01)*

(52) Cooperative Patent Classification (CPC):
**B65G 23/22; B65G 23/24; H02K 3/524; H02K 37/14; H05K 13/0419;** H02K 2203/12

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Faulhaber Precistep SA 2300 La Chaux-de-Fonds (CH)**

(72) Inventors:
• **Laoun, Magdi**
  **2300 La Chaux-de-Fonds (CH)**
• **Poliakine, Jasha**
  **2300 La Chaux-de-Fonds (CH)**
• **Linder, Michael**
  **2054 Chézard-Saint-Martin (CH)**

(74) Representative: **P&TS SA (AG, Ltd.)**
  **Avenue J.-J. Rousseau 4**
  **P.O. Box 2848**
  **2001 Neuchâtel (CH)**

(54) ## CONVEYOR TRANSPORT UNIT

(57)    The invention concerns a modular conveyor transport unit for components, comprising a conveyor frame (9), a transport wheel (4), and a two-phase hybrid stepper motor (1) comprising a stepper rotor (2) and a stator (3). The stepper motor is housed in a case (6), wherein the case is removably attached to the conveyor frame (9). The transport wheel axis (45) does not intersect the stepper motor and is attached to the conveyor frame (9) independently of the stepper motor.

Fig. 1A

EP 4 201 847 A1

Fig. 1B

Fig. 1C

EP 4 201 847 A1

**Description**

**Technical domain**

The present invention concerns a modular conveyor transport unit for transporting small components, for example small electronic devices in an industrial setting. In particular the invention concerns a modular conveyor unit driven by a hybrid stepper motor.

**Related art**

In industrial production and assembly lines, small electronic components, such as chips, are often stored and transported by means of industrial conveyor belts, also referred to as tapes. These conveyor belts are commonly used to transport small parts or small electronic devices in component placement systems for placing these components onto printed circuit boards, for packaging, or for testing. High precision, as well as speed and scalability are a prerequisite for these systems. To meet these requirements, conveyor systems depend on the reliable precision and performance of the motors driving the conveyor belts.

Hybrid stepper motors have previously been shown to be useful for driving industrial conveyors for transporting small electric devices and other components.

DE202019106519U discloses a two-phases hybrid stepper motor for driving a perforated conveyor belt, in which two stators are arranged at an angle of 140° to 170° with respect to each other in the plane of a rotor having a circumferential gearing for engaging with a perforated conveyer belt. The angular disposition of the stators exposes a section that allows the conveyor belt to engage with the circumferential gearing of the rotor.

US2018093833 describes a drive system based on a motorized roller with a primary motor, cylindrical shell containing electrically conductive or magnetic material and an external stator. The external stator interacts with the cylindrical shell to boost of buck the torque of the motorized roller.

Hybrid stepper motors allow for a precise control of the advancement of the conveyor belt in a transport system. However, the ever-increasing demand for a reliable control of transport speed, as well as for higher throughputs, whilst maintaining high precision continue to pose challenges for these stepper motor transport systems. Ideally these demands should be met without compromising on the motor's reliability, performance and precision.

**Short disclosure of the invention**

It is an aim of the present invention to provide for a conveyor transport unit driven by a hybrid stepper motor which meets these demands. The stepper motor should be precise, robust and capable of scaling.

It is a further aim of the present invention to provide a unit which is compact. The unit should be capable of easily controlling and varying the speed of the conveyer belt.

The hybrid stepper motor should furthermore be readily adaptable to different component placement systems.

Ideally, the conveyor transport unit should be robust and compact, such as to be suitable for assembly or placement systems subjected to space constraints.

According to the invention, one or more of these aims are attained by the object of the attached claims, and especially by independent claim 1.

In particular, the aims are achieved by a conveyor transport unit for electric components, comprising a preferably conveyor frame, a transport wheel rotatable about a transport wheel axis, and a two-phase hybrid stepper motor. The transport wheel axis is connected to the conveyor frame through its axis. The transport wheel axis is positioned such that it does not intersect with any part of the stepper motor.

The transport wheel may comprise a rotary encoder for determining angular movement, angular position and/or angular velocity of the transport wheel.

The two-phase hybrid stepper motor comprises a rotor and a stator.

The rotor preferably comprises two ferromagnetic rotor discs, each disc having circumferential teeth. The teeth are preferably flattened, spaced protrusions, projecting radially from the periphery of the ferromagnetic rotor disc. However, this invention is not limited to a particular shape of teeth.

The teeth are preferably regularly spaced. The teeth of the first ferromagnetic rotor disc are preferably offset with respect to the teeth of the second ferromagnetic rotor disc by an offset angle a. The two ferromagnetic rotor discs are preferably rotatable about a common rotor axis and perform their rotational movement together. This means that the angular position of the ferromagnetic rotor discs in respect of each other is fixed. Preferably the rotor axis is parallel to the transport wheel axis.

The offset angle $\alpha$ of the two rotor discs should be less than 5°. Preferably the offset angle $\alpha$ is comprised in a range from 0.5° to 5°, ideally from 0.5° to 3°. The offset angle $\alpha$ of the two rotor discs should be equal to 180° divided by the teeth count of one rotor disc, the two rotor discs having the same number of teeth.

The stepper motor further comprises a stator preferably consisting of two stator phases, wherein the stator phases and the rotor are preferably arranged in a fictional rotor plane. This arrangement allows for a space-saving flat shape of the stepper motor. The stator phases are preferably positioned on opposite sides of the rotor. In the fictional rotor plane the stator phases are preferably reversed in direction, such that they mirror each other. Each stator phase may comprise a ferromagnetic U-shaped stator core and an electromagnetic stator coil, preferably a copper wire coil, wound around the middle section of the U-shaped stator core.

The conveyor transport unit further comprises a case in which the stepper motor is housed. The case is mounted on the conveyor frame, such that it can be readily removed. The case may for example be mounted onto the conveyor frame though suitable fixation elements, such as screws or clips. Other alternatives for reversibly connecting the case to the conveyor frame are thinkable. These alternatives are equally suited, provided they permit for the case to be readily mounted onto and removed from the conveyor frame without difficulty and without using expert skill. The mounting or removing of the stepper motor can be performed without causing a long interruption in operability of the conveyor transport unit.

This provides the advantage, that a defective stepper motor contained in the case can be readily replaced without significantly disrupting the conveyor system. No individual removal of the different elements of the motor from the unit is required, when the stepper motor is contained in the case. The case containing the stepper motor may therefore be removed from the transport conveyor unit in one operation.

The case is preferably tightly fitted around the assembled rotor and stator. The case may follow the elevations of these components above the fictional rotor plane. The thickness of the stepper motor in the case should be only marginally larger than the thickness of the assembled rotor and stator, the latter corresponding preferably to the thickness of the electromagnetic stator coil.

For example, a case housing the stepper motor having a maximal transversal dimension of about 300mm to 400mm ideally has a thickness of less than 15mm, preferably less than 10mm, ideally less than 6mm.

The case can also take a very simple form. The case may for example comprise two plates, a front plate and a back plate, which are fastened to each other, and between which the stepper motor is disposed.

The case protects the stepper motor from impacts and external contamination or interference and therefore contributes to its robustness and reliability. The case also improves thermal dissipation of the heat generated by the motor. The case furthermore serves to improve the handling of the stepper motor in the modular conveyor transport unit. Due to the fact that it is contained in a case, the stepper motor can be readily mounted onto the conveyor frame. It can also be readily removed from the conveyor frame, as well as reattached at a different position or to a different conveyor frame.

In a preferred embodiment, the ferromagnetic rotor discs are iron rotor disc between which a magnetic rotor disc is layered. The magnetic rotor disc magnetizes the ferromagnetic rotor discs, such that one of the ferromagnetic rotor discs conducts the south pole, and the other ferromagnetic rotor disc conducts the north pole.

Ideally, the diameters of the two teethed ferromagnetic rotor discs are identical. Both discs have preferably the same shape. The offset angle $\alpha$ between the teeth of the ferromagnetic rotor discs is preferably chosen such that the teeth of one rotor disk superpose the gaps between the teeth of the other rotor disk.

The step-by step drive of rotor is based on a two-phase system in which alternating current passes through electromagnetic stator coils, which are preferably coiled copper wire, out of phase to build up magnetic fields. The free ends of the arms of the U-shaped stators cores preferably comprise teeth or protrusions which are match the teeth of the rotor disc in spacing and shape. The teeth of each ferromagnetic rotor disc can align with the teeth or protrusions of one of the stator phases. Upon a phase shift, the teeth of each ferromagnetic rotor disc move to align with the teeth or protrusions of the other stator phase, resulting in a stepwise rotation of the rotor.

For reason of compactness of the stepper motor, the two stator phases, which are arranged in the same fictional plane, preferably enclose an angle $\beta$ of more than 175°. The angle enclosed by the stator phases therefore is defined by the offset between the teeth of the two rotor discs.

For the rotor discs each having the same number of teeth N, the offset angle $\alpha$ is preferably

$$180° \, / \, N.$$

The angle $\beta$ is preferably:

$$180° - n * (90° \, / \, N),$$

wherein n is an odd number, for example 1, 3, 5, etc.

By aligning the two stator phases as closely as possible in a straight line without interfering with the functioning of the motor further space savings are achieved, as the space requirements in the fictional rotor plane of the assembled motor are less compared to an arrangement with stator phases enclosing a smaller angle, for example 140°. As a result, a substantially flat stepper motor is less expansive.

The transport wheel engages with the conveyor belt for transporting components. Preferably, the rotational axis of the transport wheel intersects the fictional rotor plane orthogonally. Preferably, the transport wheel does not overlap with the rotor, it may however partially overlap with the stepper rotor.

The transport wheel and the stepper motor are distinct subunits of the transport conveyor unit, which can be attached to the conveyor frame independently from each other. The transport wheel and the stepper motor are directly or indirectly interconnected, but not fixed to each other. This modular arrangement provides the distinct advantage, that the conveyor unit can be easily adapted to varying requirements.

The unit may for example be arranged such that one type of transport wheel may be replaced with another type of transport wheel.

The stepper motor is readily removable from and mountable onto a conveyor frame. It may therefore be mounted onto conveyor frames to which different types or sizes of transport wheels are attached.

Transport wheels may for example vary in size or in structure. In a preferred embodiment the transport wheel is a pin wheel with circumferential pins for intermeshing with a perforated conveyor belt. In addition, the pins may be suited for engaging with a rotatable element of the rotor, as described below. Pin sizes and/or pin spacing may vary between different transport wheels.

The type of transport wheel can be chosen to match the requirements of the conveyor belt and combined with the hybrid stepper motor, rendering the unit readily adaptable. Moreover, the speed of the translational movement of the conveyor belt may be adjusted by replacing a transport wheel with a pinned transport wheel with a different diameter, whereby a larger wheel would be used to increase the speed of the translational movement.

In a preferred embodiment the conveyor transport unit further comprises a reduction gear box. The gear box may include one or more gear wheels, wherein the rotational axes of the one or more gear wheels are attached to the conveyor frame. The axes of the one or more gear wheels do not intersect with any part of the stepper motor. The optional gear box is interconnected with the transport wheel and the stepper motor.

However, the optional gear box is not directly attached to the transport wheel or the stepper motor. This means that the gear box and its one or more gear wheels are attached to the conveyor frame independently from the stepper motor and the transport wheel.

The gear box further enhances the modularity of the conveyor transport unit and therefore its adaptability. The gear box allows for additional fine tuning of speed and control of the conveyor belt's movement.

The independent positioning of the individual subunits, which are the stepper motor, the transport wheel and the optional gear box, respectively the individual gear wheels, in the conveyor transport unit also results in a great flexibility in terms of spatial arrangement. Positions of the subunits are easily adjusted to meet specific requirements or space constraints.

In a preferred embodiment the stepper motor, the transport wheel and the optional one or more gear wheels are disposed in a substantially planar arrangement. Substantially planar means that transport wheel and the optional one or more gear wheels are arranged parallel to and in proximity to the fictional rotor plane. In proximity to the fictional rotor plane means that the subunits do not project beyond the highest elevation of the assembled stepper motor. In other words, the transport wheel and the optional one or more gear wheels are preferably arranged in planes, which are parallel to the fictional rotor plane, and which are comprised within the space defined by the thickness of the stepper motor.

Preferably the highest elevation of the assembled stepper motor is defined by the thickness of the electromagnetic stator coils. This means that the highest area of elevation of the case in respect of the fictional rotor plane is the area which covers the stator coils. Preferably the thickness of the rotor is equal to or less than the thickness of the stator coils.

The advantage of the substantially planar arrangement of the motor is the reduced width or thickness of conveyor transport unit. The flat conveyor unit allows for a serial arrangement of a plurality of transport conveyor units in parallel. Simultaneous operation of this assembly of conveyor transport units increases the throughput rate and efficiency of the system. Due to their flat shape the conveyor transport units can be densely packed in a production or placement areas for which space constraints are of concern. Optionally a plurality of conveyor transport units can be contained in a common chassis or housing. The chassis should have one or more openings for permitting a plurality of conveyor belts to interface with the transport wheels.

The case of the stepper motor preferably has an opening in a central portion of its front wall for permitting engagement of either the transport wheel, an optional gear wheel, or, optionally, a gear belt with a rotatable rotor element. The front wall of the case is the wall opposite the wall facing the conveyor frame when the case is mounted. However, it is also possible that the opening 61 is comprised in the back wall of the case, which is facing the conveyor frame.

The rotatable rotor element is preferably centred around the rotor axis and performs its movement in synchrony with the rotor discs. The rotatable element is configured to engage, directly or indirectly with either the transport wheel or with a gear wheel.

The flat arrangement of the motor, with the two stators phases arranged beside the rotor in the rotor plane, provides the advantage, that the access to the rotatable element, which may be a pinion, is improved.

A variety of embodiments are possible regarding the engagement of the transport wheel and/or the gear wheels with each other.

In one embodiment the pins of a pinned transport wheel may intermesh with the rotatable element, which may be a pinion.

In an alternative embodiment the rotatable element drives the transport wheel through a gear belt which connects the rotor with a component of the transport wheel.

In yet another embodiment the rotatable element of the rotor, which is preferably a pinion, intermeshes with a gear wheel. The gear wheel in turn drives the transport wheel. The gear wheel may drive the transport wheel directly or through a series of other gear wheels. The pinion may drive a gear train.

The gear wheel may also be driven by means of a gear belt connecting it to the rotor.

Gear belts may also be used to interconnect different gear wheels. A gear belt may be used to connect a gear wheel to a transport wheel.

The gear belts are arranged for transmitting the rotational movements between the elements they connect.

The use of gear belts adds to the positional flexibility of the modular conveyor transport system. Using gear belts results in a greater freedom in choosing the position and/or the size of the interconnecting transport and gear wheels.

**Short description of the drawings**

Examples of embodiments of the invention are disclosed in the description and illustrated by the drawings in which:

Figure 1A shows a schematic perspective view of a preferred embodiment of the conveyor transport unit;

Figure 1B shows a schematic side view of the embodiment depicted in Figure 1A.

Figures 2A, 2B and 2C illustrate the planar arrangement of essential components of an embodiment of the hybrid stepper motor, wherein

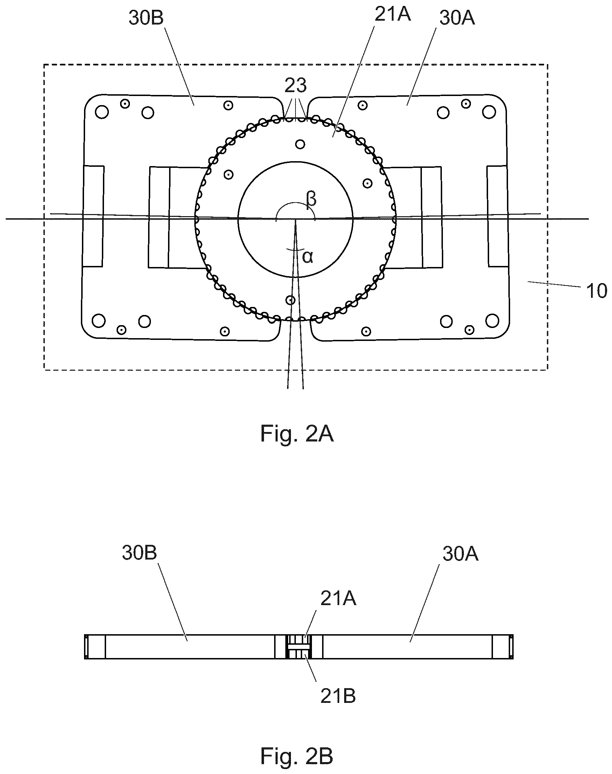

Figure 2A is a schematic top view of the ferromagnetic rotor discs and the stator arranged in the fictive rotor plane,

Figure 2B is a schematic side view of the same components, and

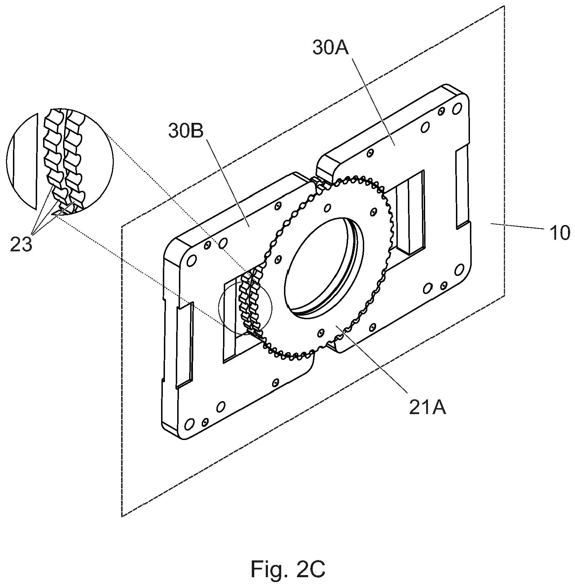

Figure 2C is a perspective view of the same components in the fictional plane.

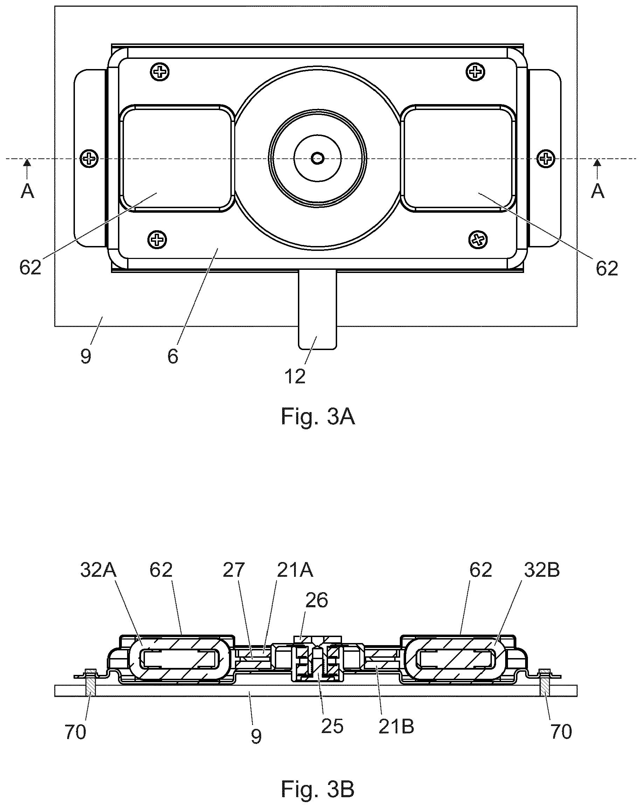

Figures 3A and 3B illustrate a possible embodiment of case housing the stepper motor, which is mounted on a conveyor frame, wherein

Figure 3A shows a schematic frontal view in which the dashed intersectional lines are marked, and

Figure 3B shows a schematic cross section along A-A of the embodiment depicted in Figure 3B,

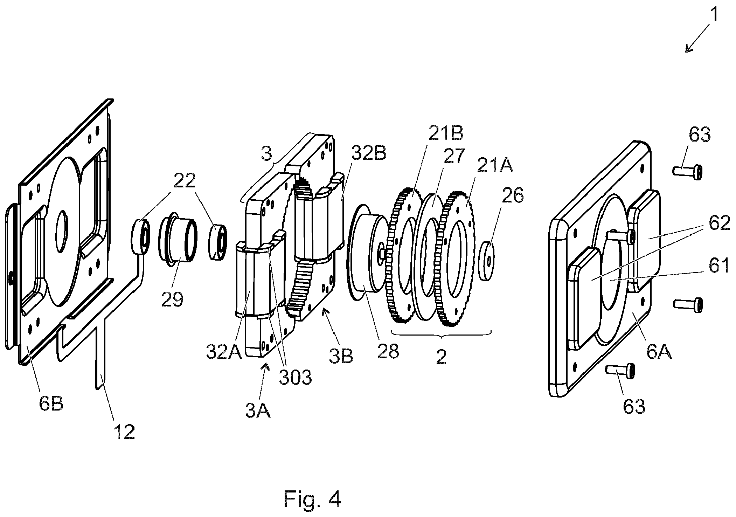

Figure 4 shows a schematic explosion view of an embodiment of the stepper motor housed in a case, and

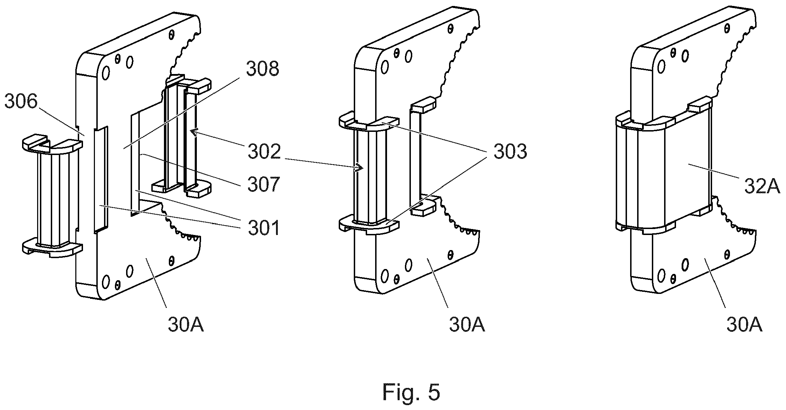

Figure 5 shows a possible example for an insulation mechanism between a U-shaped stator core and an electromagnetic coil.

**Examples of embodiments of the present invention**

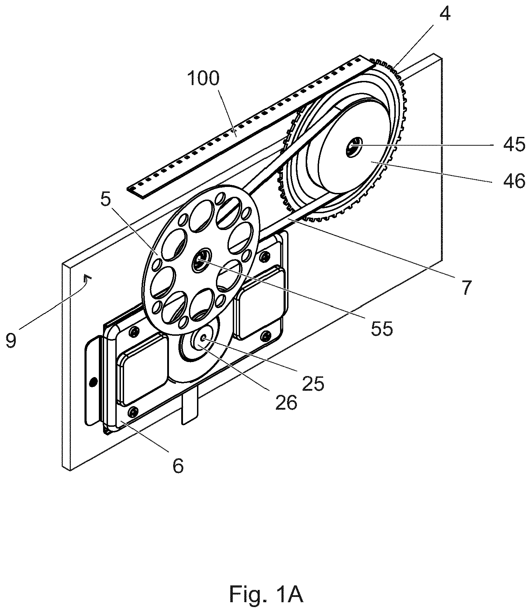

Possible embodiments of the two-phase hybrid motor 1, according to the invention, are shown in Figures 1A to 5.

Figure 1A shows a preferred embodiment of the claimed conveyor transport unit. In this embodiment the rotor discs and the stator are housed in a case 6 which is mounted on an example of a conveyor frame 9.

For simplicity, a simple rectangular conveyor frame (9) is shown in the embodiments depicted in the figures. The shape of the conveyor frame is however not limited to the example shown herein. The shape of the conveyor frame (9) should be suitable for mounting the case (6) housing the stepper motor and for arranging the case housing the stepper motor and the transport wheel (4) as claimed herein.

The case has a front opening 61 through which a rotatable element 6 of the rotor projects. The rotatable element performs its rotation about the axis or the rotor 25 together with the rotor discs, which are not visible in this figure. The conveyor frame is in an upright position, such as to permit a parallel arrangement or a series of units.

The unit shown in this figure comprises a gear box with only one gear wheel 5 which is driven by the rotatable element 26 of the rotor. The rotatable element shown here has a smooth surface. The rotatable element 26 may however also have a gearing by means of which it interfaces and drives the gear wheel 5. The rotatable element 26 may for example be a small pinion, with a diameter of less than a third, preferably less than a quarter, of the diameter of the ferromagnetic rotor discs.

The gear wheel shown here partially overlaps with the rotor discs, which are hidden in the case 6. As shown in Figures 2A and 2B, the stator 3 and the rotor 2 (Figure 4) are arranged in a fictional rotor plane 10.

Due to their varying thickness, certain portions of the rotor 2 and the stator 3 project to different degrees from the fictional rotor plane 10, giving rise to elevations. In a preferred embodiment, the case closely follows the elevations of the elements it contains, such as to minimize the thickness of the stepper motor. As a result, the case is wider in the section covering the electromagnetic coils 32A, 32B (Figure 4), giving rise to case bulges 62.

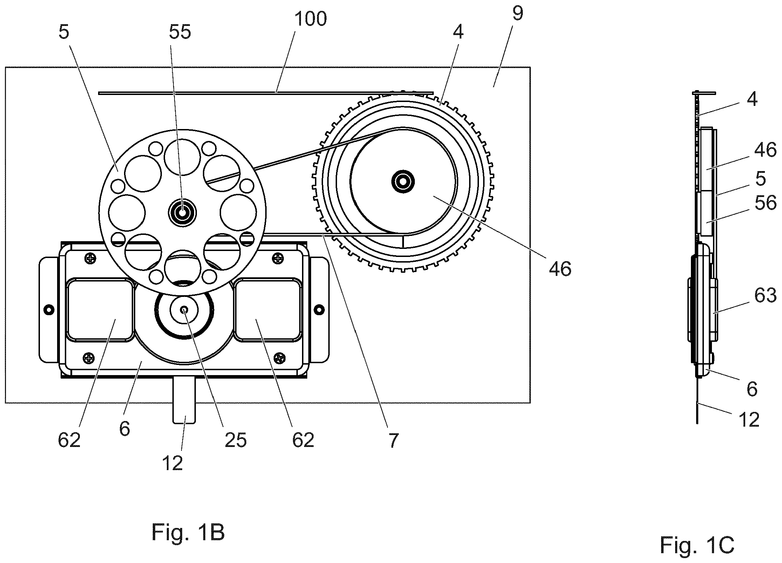

As shown in Figures 1A and 1B the gear wheel 5 is preferably positioned in the slimmer portion of the case, that is between the bulges 62 following the surface of the stator coils, such as not to add to the thickness of the overall conveyor unit.

Alternatively, the cover plate 6A of the case can also be a flat cover plate (not shown). If the either a gear wheel 5 or the transport wheel is arranged, such that it partially overlaps with the ferromagnetic rotor discs, the flat cover plate should preferably comprise a depression or recess for receiving the overlapping portion of the gear wheel or the transport wheel. By providing this depression or recess, that the thickness of the conveyor transport unit is increased as a result of the overlapping wheel.

In the embodiment depicted in Figure 5 the gear wheel 5 drives the transport wheel 4 by means of a gear belt 7, which transmits the rotational movement of the gear wheel to the transport wheel. The gear belt 7 may connect the transport wheel 4 and the gear wheel 5 by means of a transport wheel rotatable element 46 and a gear wheel rotatable element 56 (Figure 1C) which are each rotate synchronously with and are centred about the same axis 45, 55 as their respective wheel 4, 5, as shown in Figure 1A.

In an alternative embodiment (not shown) the gear wheel may directly intermesh with the rotatable element, which in this case is a small gear wheel or a pinion. The pinion may drive a gear train.

Transmitting the rotational movement through gear belts offers a greater degree of flexibility for the unit. Firstly, the gear belt permits to choose the exact position of the connected wheels in respect of each other more freely. The wheels can therefore be arranged to suit any given spatial restraints. Secondly, the gear belts 7 permit for a simple and easy exchange of wheels. Thirdly, the gear belt permits for an interconnection of different types of wheels. Wheels can be combined by means of a gear belt regardless of their specific gearing. The advantages of linking the one or more gear wheels 5 and/or the transport wheel 4 with a gear belt 7 therefore render this modular conveyor transport unit readily adaptable to specific requirements.

The transport wheel 4 is preferably a pin wheel. The pins of the pin wheel are configured to intermesh with the perforations of the conveyor band 100. The rotation of the pin wheel 4 therefore causes a translational movement of the conveyor band 100.

The rotational axis 55 of the gear wheel 5 and the rotational axis 45 of the transport wheel 4 in the embodiment shown in Figures 1A to C are both affixed to the same conveyor frame 9 onto which the case containing the stepper motor is mounted. It is however also possible, that only one of these axes is affixed to said conveyor frame 9. In this case the other axis is affixed to a different structure. Neither of the axes is however attached to the case or any other part of the stepper motor.

Preferably, the gear wheel 5, the transport wheel 4, their respective rotatable elements 46, 56, and the gear belt 7 are arranged in or parallel to the fictional rotor plane 10. These elements should be arranged, such that they do not project beyond the thickness of the case 6 of the stepper motor, as shown in Figure 1B.

Figures 2A to 2C depict a preferred planar arrangement of two U-shaped stator cores 30A, 30B, which are shown without the electromagnetic stator coils, and two ferromagnetic rotor discs 21A, 21B of the stepper motor. The components of a preferred embodiment of the rotor 2 and of the stator 3 are also shown in the explosion view of Figure 4.

The rotor of the two-phased stepper hybrid motor comprises two ferromagnetic rotor discs 21A, 21B with circumferential teeth 23 and a magnetic disc 27 (shown in Figure 4) which is arranged between the two ferromagnetic rotor discs in a sandwich arrangement. The ferromagnetic rotor discs 21A, 21B and the magnetic discs 27 perform their rotational movement synchronously about the axis 25 of the rotor.

One of the two ferromagnetic rotor disc conducts the south pole, and the other iron rotor disc conducts the north pole of the magnetic rotor disc 27, such as to enable the rotational movement of the rotor.

The teeth 23 of the two ferromagnetic rotor discs shown in the Figures are offset from each other, such that the teeth of one ferromagnetic rotor disc 21A cover the gaps between the teeth of the other ferromagnetic rotor disc 21B. The teeth of the two ferromagnetic rotor discs are offset with respect to each other by the offset angle $\alpha$, indicated in Figure 2A.

The rotor discs in the embodiment shown in Figures 2A each have 50 circumferential teeth. The offset angle $\alpha$ calculated as $360° / N$, whereby N is the number of teeth, is 7.2° in this example.

The angle $\beta$ enclosed by the stator phases in the example depicted in Figure 2A, is 178.2°, i.e. 180° minus 1.8°. This angle is calculated using the formula

$$180° - n * (90° / N),$$

wherein N is the number of teeth, 50 in this example, and n is an odd number, which is 1 in the example shown.

The two-phased hybrid stepper motor consists of two stator phases 3A, 3B, each composed of a U-shaped stator core 30A, 30B and an electromagnetic stator coil 32A, 32B. The electromagnetic stator coils is preferably a copper wire coil. The stator coil is wound about a stator core's middle section, which is the section connecting the two arms of the U-shaped stator core.

The stator cores 30A, 30B, which are disposed on opposite sides of the rotor 2 in the rotor plane 10, are mirror facing each other. In order to minimize the space requirement of the flat stepper motor, it would be desirable to arrange the stator phases in a straight line. However, in order for the phase shift of the stators to drive the rotor, the angle enclosed by the stator phases account for the offset angle $\alpha$ between the ferromagnetic rotor discs. To reduce space requirements, the deviation from 180° of the angle $\beta$ enclosed between the stator phases should be kept low. The angle $\beta$ is preferably no less than 175°.

As shown in Figures 2A to 2C, the free ends of the arms of the U-shaped stator cores 30A, 30B preferably has radially projecting teeth or protrusions which can be aligned with the teeth 23 of the ferromagnetic rotor discs 21A, 21B. the stator cores 30A, 30B and ferromagnetic rotor discs 21A, 21B are arranged in such a way that the teeth of one stator core align with the teeth of one ferromagnetic rotor disc, and the teeth of the other stator core align with the teeth of the other ferromagnetic rotor disc. The teeth are aligned without contacting each other.

The step-by step drive of rotor 2 is based on a two-phase system in which alternating current passes through the electromagnetic stator coils 32A, 32B out of phase to build up magnetic fields. The teeth 23 of each ferromagnetic rotor disc are aligned with the teeth or protrusions of one of the stator phases. Upon a phase shift, the teeth of each ferromagnetic rotor disc move to align with the teeth or protrusions of the other stator phase, resulting in a stepwise rotation of the rotor.

The length of the arms of the stator cores 31A, 31B may be chosen, such as to establish a sufficient or optimum distance between the middle portion of the stator core and the rotor to increase the amount of copper, respectively the number of wire windings, in the stator coil. The length of the arms may be chosen such as to create a sufficiently large distance between the electromagnetic stator coil and the rotor to prevent overheating.

A possible embodiment of the stepper motor housed in a case 6 is shown in Figures 3A and 3B, which represent a frontal view of the stepper motor mounted on the conveyor frame 9 and a cross section of this embodiment along the line A-A.

In the cross-section of Figure 3B the central axis 25 of the rotor about which the two teethed ferromagnetic rotor discs 21A, 21B as well as the interposed magnetic rotor disc 27 rotate, is visible. Figure 3B also depicts the housing of the electromagnetic coils 32A, 32B in the outward bulging portion of the case 62.

The fixation elements 70 for mounting the case 6 housing the stepper motor onto the conveyor frame 9 shown in Figures 3A and 3B are screws. Other suitable fixation elements may be used instead.

Further details and components of an exemplary embodiment of the claimed hybrid stepper motor are shown in the schematic explosion view of Figure 4.

The stepper motor is contained in a case comprising a front cover 6A and a back cover 6B being attached to each other by fixation means 63. This fixation means can be screws, clips or other suitable fixtures. In the embodiment shown in the Figures, the case encloses the motor almost entirely, with exception of the opening 61.

It is however also possible, that the case contains only a front and a back cover but is open along the lateral sides. The front and back cover in this embodiment should be so connected, that the case containing the motor can be removed from the conveyor transport unit jointly as one single entity.

In addition to the elements already described above, this embodiment comprises further optional elements, which can be provided together or separately in different embodiments of this invention. Figure 4 shows a support for the two ferromagnetic rotor discs 28, the rotatable element 26, bearings 22 and a bearing support 29. These elements perform their rotational movement together with the ferromagnetic rotor discs 21A, 21B.

The shown embodiment also comprises a flex 12 with electric wires providing electric current to the electromagnetic stator coils 32A, 32B. However, electric current can also be supplied by another means, for example by cables or a connector.

The front cover 6A of the case has an opening 61 though into which the rotor support is inset. The rotatable element 26 projects outwards through this opening. As described above, the rotatable element can engage with a gear wheel 5 or with a transport wheel 4. Alternatively, it is also possible that a rotatable element 26 drives a gear belt 7 connected with a gear wheel 5 or the transport wheel 4.

In order to optimise spatial efficiency and to improve the space saving parallel arrangement of the flat stepper motor, the motor should be kept as slim as possible without compromising on performance. As mentioned above, the thickness of the motor is primarily defined by the stator coils 32A, 32B, which are wound around the respective ferromagnetic stator cores 30A, 30B.

A common solution to reduce electrical losses and therefore increase the efficiency of a hybrid motor is to increase the packaging weight of the electromagnetic coil windings about the stator. However, a larger number of windings results in an increased motor size, which again is undesirable for micromotors or flat motors.

To further optimise the use of available space the inventors set out to find a mechanism which permits to further reduce a compact motor size without compromising on the motors efficiency by reducing the windings of the electromagnetic coil. The approach taken here focussed on the insulation mechanism preventing electrical leakage between the electromagnetic wire coil and the ferromagnetic stator.

Conventionally, non-conducting insulation sheets or adhesive insulation band are disposed between stators and wire coils, which are preferably copper wire coils in micromotors. These sheets, which usually have a thickness between 0.1mm and 1mm, are disposed on the surface area of a stator about which the magnetic wire is wound, increasing the volume of the motor. The additional volume is extremely undesirable in flat motors or micromotors, for which space efficiency is adamant.

In addition, the insulation sheets and/or bands have edges, which can damage the fine copper wires of the coil when the wires rub or are pressed against them. As a result, the risk of a short circuiting is relatively high for coils made of thin wires.

In the example shown in Figure 5, the isolation sheet or insulation band was entirely omitted. Instead, the ferromagnetic stator core is further equipped with lateral insulation covers 302 which are fitted in a tapered portion, or a recess portion 301 of the stator core section about which the electromagnetic stator coil is wound, in such a way that the wire of the coil only touches the insulation covers but not the ferromagnetic stator core in its wound state. This is achieved, by considering the geometry of the stator core section about which the wire is wound, and by providing tapered portions or recesses 301 for accommodating insulation covers 302 in those portions, which contact the coiled wire.

An insulation cover 302 is preferably inserted into a tapered portion or a recess 301. In order to avoid an increase of the volume and/or the thickness of the motor, the cover should connect flush with the adjoining surface of the stator core. Preferably, the insulation cover does not project above the plane of the adjoining outer surface of the stator core.

Unlike insulation sheets or insulation bands the insulation cover presented herein does not expose the wire of the coil to sharp edges. The risk of a short circuit is therefore significantly reduced.

The number of insulation covers 302 can vary depending on the geometry of the stator core section, which receives the stator coil. The insulation cover is preferably fitted along the edges of this section. For example, if this section has a rectangular or a square cross-section, recesses 301 for inserting insulation covers 302 could be positioned along the four edges of this section.

This insulation mechanism can be easily combined with the flat stepper motor described above. The insulation mechanism is however not limited to this type of motor and is equally suited for other types of motors, for which space efficiency is important, such as micromotors.

Figure 5 shows a preferred embodiment of a flat U-shaped stator core, such as described above. In this embodiment two insulation covers are fitted on the opposing thin sides of the middle section, whereby each insulation cover folds around a thin side of the stator coil-receiving middle section and is inset in two recesses along the edges of the thin side.

The shape of the middle section of the U-shaped stator core 30A shown in Figure 5 corresponds essentially to a rectangular cuboid with recesses 301 along its four edges. Two insulating covers 302 are inserted into the recesses 301, such that each insulation cover folds from one recess over the inner 306, respectively the outer 307 lateral surface of the middle section into another recess. The insulation covers are inserted into the two recesses 301, such that they form a continuation of the surface plane of the central portion 308 of the middle section. The insulation covers connect flush with the outer surface of the central portion 308. However, they project laterally above the inner 306, respectively the outer 307 lateral surfaces on the thin sides of the middle section.

It is also possible to join the two recesses by means of an additional recess running between the two recesses along their length, such that the insulating element can be inserted therein. This arrangement would allow for a flush connection between the insulation cover 302 and the lateral surfaces 306, 307. This alternative is particularly desirable if not only the thickness, but also the width of the motor needs to be kept at a minimum.

The insulating covers shown in Figure 5 comprise lips 303, which are disposed to contain the electromagnetic stator coil within a region defined by the insulating cover. The lips 303 prevent the stator coil from slipping along the thin sides of the middle section and from slipping of the insulation cover and onto the ferromagnetic stator core.

When wound around the middle section, the electromagnetic stator coil contacts the insulation covers around the lateral sides 307, 308 and cambers outwards over the ferromagnetic central portion 308 of the stator core. Due to the curvature of the wound coil, the wire does not contact the central portion 308 of the middle section. An electric leakage between electromagnetic stator coil and stator core is therefore avoided.

It is understood that various embodiments and modifications of the present preferred embodiment described herein will be obvious to those skilled in the art. To the extent that these embodiments and modifications do not depart from the scope of the claims, it is intended that they are also included in the invention disclosed herein.

**Claims**

1. A conveyor transport unit for components, comprising

   - a conveyor frame (9),
   - a transport wheel (4) with a transport wheel axis (45), and
   - a two-phase hybrid stepper motor (1) comprising a stepper rotor (2) and a stator,

   **characterized**

   - **in that** the unit further comprises a case (6) for accommodating the stepper motor, said case being removably attached to the conveyor frame (9), and
   - **in that** the transport wheel axis (45) is mounted onto the conveyor frame (9), such that said transport wheel axis (45) does not intersect the stepper motor (1).

2. The unit of claim 1, said transport wheel being directly engaged with said stepper rotor or with a rotatable element (26) on the axis (25) of said roto r.

3. The unit of claim 1, further comprising a reduction gear box comprising one or more gear wheels (5), one of said gear wheels being directly engaged with said stepper rotor, and wherein the rotational axes (55) of the one or more gear wheels (5) are mounted to the conveyor frame (9), such that the axes do not intersect the stepper motor (1).

4. The unit of claim 3, said reduction gear box comprising a belt between said gear wheels and/or between one said gear wheel and said transport wheel.

5. The unit of one of the claims 1 to 4, said two-phase hybrid stepper motor having two ferromagnetic rotor discs (21A, 21B) with circumferential teeth (23), wherein the teeth of the first ferromagnetic rotor disc (21A) are offset with respect to the teeth of the second ferromagnetic rotor disc (21B) by an offset angle $\alpha$, and wherein the two ferromagnetic rotor discs are rotatable about the common rotor axis (25).

6. The unit of claim 5, further comprising a magnetic rotor disc (27) which is layered between the two ferromagnetic rotor discs (21A, 21B).

7. The unit of one of the claims 5 or 6, said two-phase hybrid stepper motor having a stator (3) consisting of two stator phases (30A, 30B), wherein the stator phases are positioned on opposite sides of the rotor in a fictional rotor plane (10), each stator phase comprising a ferromagnetic stator core (31A, 31B) and an electromagnetic stator coil (32A, 32B) wound around said U-shaped stator core (31A, 31B).

8. The unit of claim 7, wherein the two stator phases (30A, 30B) are arranged in the fictional rotor plane (10) and enclose an angle $\beta$, which equals

$$180° - n*(90°/N),$$

wherein n is an odd number, for example 1, 3, or 5, and wherein N is the number of teeth of one rotor disc.

9. The unit of any of claims 1 to 8, wherein the rotor axis (25), the transport wheel axis (45), and the optional one or more gear wheel axes (55) are parallel to each other, and wherein the transport wheel axis (45) and the optional one or more gear wheel axes (55) intersect orthogonally with the surface of the conveyor frame (9).

10. The unit of any of claims 1 to 9, wherein the stepper motor (1), the transport wheel (4) and the optional one or more gear wheels (5) are disposed in a substantially planar arrangement.

11. The unit of any of claims 1 to 10, wherein one or more of the transport wheel (4), the hybrid stepper motor (1), and/or the optional gear box (5) are removably connected to the conveyor frame (9).

12. The unit of any of claims 1 to 11, the thickness of the rotor being equal to or less than the thickness of the electromagnetic stator coils.

13. The unit of any of claims 1 to 12, wherein the case (6) comprises an opening for enabling the engaging of the stepper rotor or the rotatable element (26) with the gear wheel (5) or the transport wheel (4).

14. The unit of any of claims 1 to 13, wherein the transport wheel (4) is a pin wheel suited for engaging with and for driving a perforated industrial conveyer belt (100).

15. The unit of any of claims 1 to 14, further comprising a rotary encoder for determining the angular movement, angular position, and/or angular velocity of the transport wheel (4).

16. A system comprising a plurality of units of any of claims 1 to 15 arranged in parallel.

Fig. 1A

Fig. 1B

Fig. 1C

EP 4 201 847 A1

30B      21A   30A

23

β

α

10

Fig. 2A

30B          30A

21A

21B

Fig. 2B

Fig. 2C

Fig. 3A

Fig. 3B

Fig. 4

EP 4 201 847 A1

Fig. 5

| | Europäisches Patentamt European Patent Office Office européen des brevets | **EUROPEAN SEARCH REPORT** | Application Number EP 21 21 6562 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Antony Cartwright: "INVESTIGATING: My DIY Arduino Stepper Motor Conveyor-Belt! With L9110!", , 30 May 2020 (2020-05-30), XP055922777, Retrieved from the Internet: URL:https://www.youtube.com/watch?v=Ce3aBYVCn9g [retrieved on 2022-05-18] * the whole document * | 1,3,4, 9-11,13 | INV. B65G23/22 B65G23/24 H02K1/18 H02K7/06 H02K7/116 H02K37/12 H05K13/04 |
| A,P | Roboter-Bausatz.De: "ACT Nema 17 Schrittmotor 17HS3404 12V 0.4A 34mm ¦ Roboter-Bausatz.de", , 18 May 2022 (2022-05-18), XP055922776, Retrieved from the Internet: URL:https://www.roboter-bausatz.de/p/act-nema-17-schrittmotor-17hs3404-12v-0.4a-34mm [retrieved on 2022-05-18] * page 2 * | 1,3,4, 9-11,13 | |
| A,P | Act Motor Gmbh: "ACT Motor GmbH Specifications / Mechanical Dimensions / Connections Phase 2 Phase", , 18 May 2022 (2022-05-18), XP055922773, Retrieved from the Internet: URL:https://www.roboter-bausatz.de/media/pdf/9f/43/8c/RBS12799-17HS3404-Datasheet.pdf [retrieved on 2022-05-18] * page 1 * | 1,3,4, 9-11,13 | TECHNICAL FIELDS SEARCHED (IPC) B65G H02K H05K |

-/--

The present search report has been drawn up for all claims

| Place of search | Date of completion of the search | Examiner |
|---|---|---|
| The Hague | 19 May 2022 | Thibaut, Charles |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2018 014436 A (JUKI KK) 25 January 2018 (2018-01-25) <br><br> * claim 1 * <br> * figures 1-13 * <br> * paragraph [0001] - paragraph [0153] * <br> ----- | 1,3, 9-11, 13-16 | |
| X | DE 20 2019 106519 U1 (FAULHABER PRECISTEP SA) 16 January 2020 (2020-01-16) <br> * claim 1 * <br> * figures 1-11 * <br> * paragraph [0001] - paragraph [0029] * <br> * paragraph [0031] - paragraph [0053] * <br> ----- | 1-3,5-14 | |
| Y | CN 107 666 783 A (SHENZHEN FAROAD INTELLIGENT EQUIPMENT CO LTD) 6 February 2018 (2018-02-06) <br> * claim 1 * <br> * figures 1-2 * <br> * paragraph [0001] - paragraph [0028] * <br> ----- | 1,3, 9-11, 13-15 | |
| Y | US 2013/154405 A1 (TRUNG NGUYEN THANH [JP] ET AL) 20 June 2013 (2013-06-20) <br><br> * claim 1 * <br> * figures 1-8 * <br> * paragraph [0001] - paragraph [0050] * <br> ----- | 1,3, 9-11, 13-15 | TECHNICAL FIELDS SEARCHED (IPC) |
| A | WO 2009/110597 A1 (PULSE KABUSHIKI KAISHA I [JP]; MURAMATSU HIROKATSU [JP]) 11 September 2009 (2009-09-11) <br> * figure 5 * <br> ----- | 2-4 | |

The present search report has been drawn up for all claims

| Place of search | Date of completion of the search | Examiner |
|---|---|---|
| The Hague | 19 May 2022 | Thibaut, Charles |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 21 6562

This annex lists the patent family members relating to the patent documents cited in the above-mentioned European search report.
The members are as contained in the European Patent Office EDP file on
The European Patent Office is in no way liable for these particulars which are merely given for the purpose of information.

19-05-2022

| Patent document cited in search report | | Publication date | Patent family member(s) | | Publication date |
|---|---|---|---|---|---|
| JP 2018014436 | A | 25-01-2018 | CN | 107645901 A | 30-01-2018 |
| | | | JP | 6714964 B2 | 01-07-2020 |
| | | | JP | 2018014436 A | 25-01-2018 |
| DE 202019106519 | U1 | 16-01-2020 | NONE | | |
| CN 107666783 | A | 06-02-2018 | NONE | | |
| US 2013154405 | A1 | 20-06-2013 | CN | 102957298 A | 06-03-2013 |
| | | | EP | 2566020 A2 | 06-03-2013 |
| | | | JP | 2013048498 A | 07-03-2013 |
| | | | US | 2013154405 A1 | 20-06-2013 |
| WO 2009110597 | A1 | 11-09-2009 | JP | 4814302 B2 | 16-11-2011 |
| | | | JP | 2009239253 A | 15-10-2009 |
| | | | WO | 2009110597 A1 | 11-09-2009 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 202019106519 U

- US 2018093833 A